Europäisches Patentamt

European Patent Office

Office européen des brevets

(11) Publication number: **0 037 200**
**B1**

## (12) EUROPEAN PATENT SPECIFICATION

(45) Date of publication of patent specification: **20.03.85**

(21) Application number: **81301073.3**

(22) Date of filing: **13.03.81**

(51) Int. Cl.⁴: **H 01 L 29/80,** H 01 L 29/10

(54) Charge coupled device with buried channel stop.

(30) Priority: **31.03.80 US 135554**

(43) Date of publication of application:
**07.10.81 Bulletin 81/40**

(45) Publication of the grant of the patent:
**20.03.85 Bulletin 85/12**

(84) Designated Contracting States:
**DE FR GB NL**

(56) References cited:
**GB-A-2 009 506**

**Article by Y.Z. LIU et al in "International
Electron Devices Meeting, Washington DC,
1979, December 3-5**

(73) Proprietor: **Hughes Aircraft Company
Centinela Avenue and Teale Street
Culver City, California 90009 (US)**

(72) Inventor: **Clark, Marion D.
11725 Montana Avenue Apt. 20
Los Angeles California 90049 (US)**

(74) Representative: **Milhench, Howard Leslie et al
A.A. Thornton & Co. Northumberland House
303/306 High Holborn
London, WC1V 7LE (GB)**

Courier Press, Leamington Spa, England.

## Description

This invention relates to charge coupled devices (CCDs). More specifically, it relates to CCDs utilized in image sensing arrays.

While the present invention is described herein with reference to particular embodiments, it should be understood that the invention is not limited thereto. The CCDs of the present invention may be adapted and employed for a variety of requirements as those skilled in the art will recognise in the light of the present disclosure.

It is widely accepted that the charge coupling principle can be applied to fulfil a number of information processing requirements. In particular, charge coupled devices have demonstrated a ready adaptability to image sensing applications. The semiconductor materials of which charge coupled devices are generally fabricated, silicon and gallium-arsenide, are highly sensitive to visible and near infrared radiation. The absorption of light energy by these materials results in a generation of electrons in a quantity proportional to the amount of incident light. These electrons can be held in a potential well in the CCD substrate. Potential wells are created by applying a voltage to an electrode mounted on the surface of the device.

Since each CCD is capable of providing a potential well, an array of potential wells may be provided in an image sensor having an array of CCDs. Electrons will fill these wells to a level corresponding to the light in the immediate vicinity. These packets of electrons can then be shifted to a point of detection in a manner well known in the CCD art. An electrical signal is thereby generated which is representative of the optical image incident on the device.

CCD image sensors offer several advantages over silicon-diode image sensors and cathode ray tubes. In addition to allowing for an inexpensive, compact, lightweight integrated circuit construction, CCDs require a low operating voltage and offer self-scanning of the photosensitive array.

In a camera tube, the video image is read from a photosensitive material by a scanning electron beam. The exact position of the beam is never precisely known because of the uncertainty in the sweep circuits due to random electrical noise. However, in charge coupled image sensors, individual photosensor sites are known with an exactitude predetermined during manufacture of the component. This allows for an accurate self-scan of the photosensitive array.

Another important property of an image sensor is its spatial resolution. Resolution of charge coupled image sensors is directly related to the concentration of image sensing elements in a given area. The concentration of image sensing elements is limited by the size and shape of each element.

As is known to those skilled in this art, the resolution of the sensor would be greatest where the charge coupled device had the highest possible yield of image sensing elements. To achieve a high yield, the photosensing elements should have a planar geometric shape so as to allow a close interfitting of neighboring elements.

It has been shown that in the image sensing application buried channel charge coupled devices exhibit more desirable noise characteristics than surface channel charge coupled devices.

As mentioned above, charge coupled image sensors require an array of image sensing elements. Each element acts as an individual CCD. Conventional CCDs typically require a gate electrode, a layer of insulating material, and a substrate. The insulating layer adds to the size of each element and the cost of its fabrication.

It is known in the art that the insulating layer is not required where rectifying gate electrodes are employed. This construction provides for an overlay of p-type material on an n-type substrate or vice-versa. Care must be exercised to insure that the electrode does not extend beyond the edge of the channel. This presents a fabrication problem requiring the use of manufacturing techniques that add to the cost of making the device.

In order to keep the signal charges confined in a preferred lateral direction, some method of defining the charge transfer channel must be employed. Prior art techniques for defining the storage and transfer channels in planar, buried channel CCDs with rectifying contact gates typically require a biased guard ring electrode surrounding the channel area. This construction, however, does not allow the gates to be extended beyond the edge of the channel.

It has previously been proposed in a paper by Y.Z. Liu et al., entitled "Ga Al As/Ga As Heterojunction Schothby Barrier Gate CCD" presented to the International Electron Devices Meeting in Washington D.C., on December 3, 4 and 5, 1979, to provide a charge coupled device having a p-type GaAs substrate with an n-type planar region at least partially overlying the substrate. Channel stop means are disposed in the p-type GaAs layer and a plurality of gate electrodes make rectifying contact with the n-type planar region. In this proposal, the channel stop means extend also in the n-type planar region. Further, the channel stop means are provided by proton bombardment.

It has also previously been proposed in G.B. 2,009,506B to provide a semiconductor image sensor comprising a rectangular array of charge collection elements buried in a semiconductor wafer for collecting charge photogenerated in response to the image. A plurality of charge transfer devices controlled by electrode sets extend in a row direction over transfer channels. A part of the wafer in which the charge collection elements are buried is provided with a graded doping concentration profile which creates an in-built electric field which will drive charge-carriers of one sign towards the charge collection elements. Channel stops comprising heavily doped semiconductor regions are also provided.

The present invention provides a charge coupled device having a first planar region of semiconductive material and a second planar region of semiconductive material at least partially overlying said first planar region, buried channel stop means disposed in said first planar region and presenting a spatial variation of the electrically active impurity concentration in the said first planar region for electrostatic confinement of mobile charge carriers in said second planar region so as to define an electrostatic channel therein and a plurality of parallel coplanar gate electrodes which extend continuously over said buried channel stop means and make rectifying contact with said second planar region.

In such a device, no insulating layer is required between the gate electrode and the substrate and channel definition is accomplished by use of channel stops in the buried channel layer rather than the overlying channel layer. This allows construction of planar surface buried channel CCDs with rectifying contacts which extend continuously over the channel stop region. This reduces the cost and greatly simplifies the fabrication of the gate array. The present invention allows a CCD structure that is particularly applicable to image sensors, memories and other devices that require several parallel transfer channels contiguous to one another.

In order that the present invention be more readily understood, embodiments thereof will now be described by way of example with reference to the accompanying drawings, in which:—

Figure 1 illustrates a perspective partially in phantom of a buried channel CCD with the buried channel stops of the present invention;

Figure 2 is a graphical representation of the electrostatic potential variation in the structure of the present invention;

Figure 3 depicts a side-elevational view of a cross-section of an alternative embodiment utilising the principles of the present invention; and

Figure 4 shows a side-elevational view of a cross-section of a second alternative embodiment utilising the principles of the present invention.

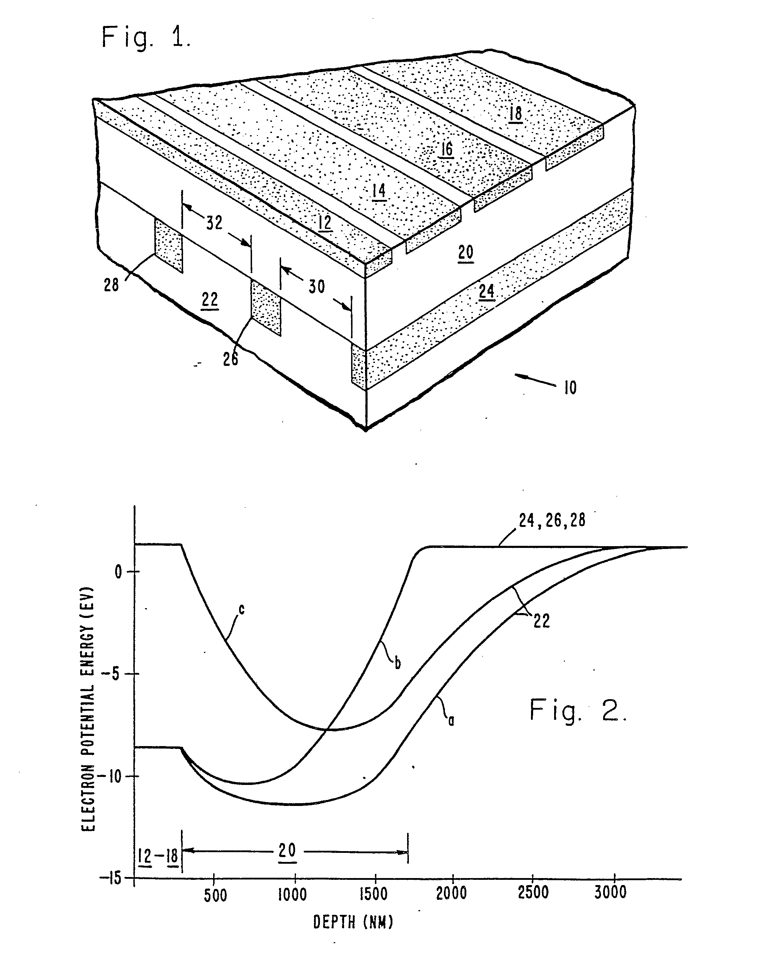

Figure 1 shows a preferred embodiment of a buried channel CCD 10 utilising the principles of the present invention. P+ regions 12, 14, 16 and 18 serve as transfer gates and make rectifying contact to the n-type channel layer 20. Underlying the n-type channel layer 20 is a p-layer 22. P-type layer 22 is necessary to achieve the buried channel electrostatic potential configuration. P+ regions 24, 26 and 28 are buried channel stops.

As shown in Figure 1 these channel stops 24 through 28 are effective to define the width of channels 30 and 32 in n-type region 20 in a manner known to those skilled in the art. Regions 24, 26 and 28 are obtained by selectively increasing the impurity concentration of region 22 by ion implantation or diffusion before the n-type layer 20 is deposited by epitaxial crystal growth. Transfer gates 12, 14, 16 and 18 are then formed on the n-type layer 20 in a manner known to those skilled in the art, i.e., ion implant or epitaxial growth. Gates, 12, 14, 16 and 18 may be positively doped p-type regions or Schottky barrier metal electrodes.

The electrostatic potential configurations of CCD 10 are illustrated in Figure 2. Curve (a) represents electron potential energy as it varies in depth below the surface of the semiconductor within a charge transfer channel. Curve (a) was obtained in holding the transfer gate at 10 volts and applying a signal charge of $5.65 \times 10^{11}$ electrons/cm$^2$.

Curve (b) of Figure 2 represents potential energy in the adjacent channel stop region under the same gate at 10 volts. The greater minimum potential energy in the channel stop area confines charge to the channel.

Curve (c) represents the potential in the channel region under a gate that is biased at zero volts. Note the higher minimum potential energy of curve (c) as compared to curve (a). It shows that electrons will be confined to the channel under a gate biased at 10 volts when the adjacent gates are biased at zero volts.

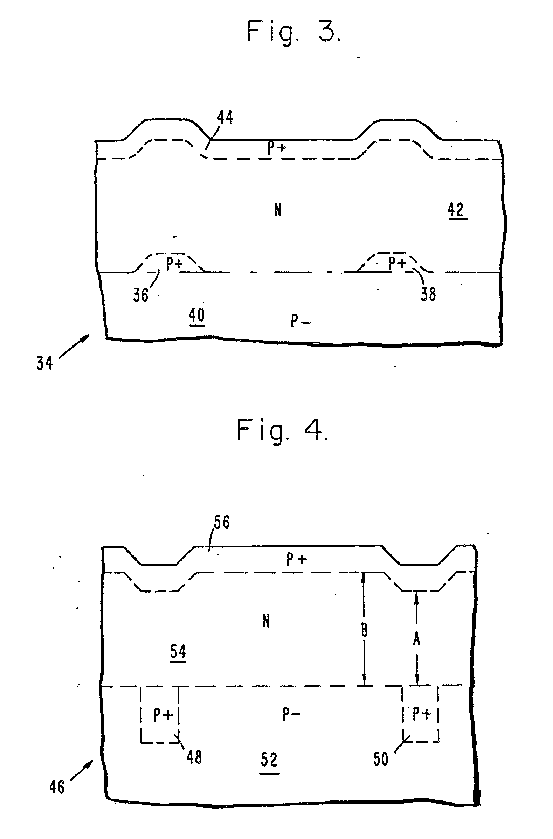

Figure 3 illustrates in cross section an alternative embodiment 34 functionally equivalent to CCD 10 of Figure 1. The configuration of CCD 34 would be achieved by forming strips of p+ epitaxial material 36 and 38 on the p— buried layer 40. Strips for buried channel stops 36 and 38 may be formed by selective growth, or by uniform growth followed by selective removal. The n-type channel layer 42 may then be added by epitaxial growth. P+ junction or Schottky barrier gate 44 is formed over layer 42 by an appropriate technique.

Figure 4 illustrates in cross section a CCD 46 which is a modification of the configuration of Figure 1. This embodiment offers increased signal charge capacity. Buried channel stops 48 and 50 are implanted in a buried p— region 52. The n-type channel layer 54 and gate 56 are added as described above to complete the structure. Note that the thickness of the channel layer over the channel stops, dimension A is made less than the thickness in the channel area, dimension B. The surface topology of structures 34 and 46 shown in Figures 3 and 4 constitute departures from strictly planar devices. However, the heights of surface features required for these structures are small enough that these would be considered "planar" structures in the context of microelectronic technology.

While preferred embodiments of this invention have been described, it will be understood that the invention is not limited thereto. Considering the foregoing teachings, modifications may be made within the scope of this invention by one of ordinary skill in the art to which this invention pertains. For example, gallium arsenide (GaAs) is utilised in the preferred embodiment because GaAs CCDs offer improved radiation hardness and a longer charge storage time than silicon CCDs. However, the present invention is also applicable to CCDs made of any material, especially, where rectifying gate contacts are preferred for reasons of device performance. In particular, the transfer gates may be formed by n+ doping and, make contact with a planar region of p− type doping. In that case, underlying the p− type doping layer would be an n− type doping planar layer. This in turn would mean that the channel stop means would be of n+ doping and the mobile charge carriers would be holes.

## Claims

1. A charge coupled device having:
a first planar region (22) of semiconductive material and
a second planar region (20) of semiconductive material at least partially overlying said first planar region, buried channel stop means (24, 26, 28) disposed in said first planar region and presenting a spatial variation of the electrically active impurity concentration in the said first planar region for electrostatic confinement of mobile charge carriers in said second planar region so as to define an electrostatic channel therein and a plurality of parallel coplanar gate electrodes (12, 14, 16, 18) which extends continuously over said buried channel stop means and make rectifying contact with said second planar region.

2. A device according to claim 1 wherein said first planar region (22) is of a p− doping, said second planar region (20) is of n-type doping, said gate electrodes (12, 14, 16, 18) are of p+ doping, said channel stop means (24, 26, 28) comprises a plurality of parallel coplanar regions of p+ doping and said mobile charge carriers are electrons.

3. A device according to claim 1 wherein said first planar region (22) is of n− doping, said second planar region (20) is of p-type doping, said gate electrodes (12, 14, 16, 18) are of n+ doping, said channel stop means (24, 26, 28) comprises a plurality of parallel coplanar regions of n+ doping and said mobile charge carriers are holes.

## Patentansprüche

1. Ladungsgekoppelte Vorrichtung mit
einem ersten planaren Bereich (22) aus Halbleiter-Material und
einem zweiten planaren Bereich (20) aus Halbleiter-Material, der den ersten planaren Bereich wenigstens teilweise überlappt,
mit in dem ersten planaren Bereich angeordneten, vergrabenen Kanalbegrenzungszonen (24, 26, 28), die in einer räumlichen Variation der Konzentration der elektrisch aktiven Verunreinigungen in dem ersten planaren Bereich bestehen und ein elektro-statisches Einschließen beweglicher Ladungsträger in dem zweiten planaren Bereich bewirken, was die Erzeugung von elektrostatischen Kanalzonen in diesem Bereich zur Folge hat, und mit einer Anzahl paralleler und coplanarer Gate-Elektroden (12, 14, 16, 18), die sich ohne Unterbrechung über die vergrabenen Kanalbegrenzungszonen erstrecken und mit dem zweiten planaren Bereich in gleichrichtendem Kontakt stehen.

2. Vorrichtung nach Anspruch 1, bei der der erste planare Bereich (22) p⁻-dotiert ist, der zweite planare Bereich vom n-Typ ist, die Gate-Elektroden (12, 14, 16, 18) p⁺-dotiert sind, die Kanalbegrenzungszonen (24, 26, 28) aus einer Anzahl paralleler und in einer gemeinsamen Ebene angeordneten p⁺-dotierter Bereiche besteht und die mobilen Ladungsträger Elektronen sind.

3. Vorrichtung nach Anspruch 1, bei der der erste planare Bereich (22) n⁻-dotiert ist, der zweite planare Bereich vom p-Typ ist, die Gate-Elektroden (12, 14, 16, 18) n⁺-dotiert sind, die Kanalbegrenzungszonen (24, 26, 28) aus einer Anzahl paralleler und in einer gemeinsamen Ebene angeordneten n⁺-dotierter Bereiche besteht und die mobilen Ladungsträger Löcher sind.

## Revendications

1. Un dispositif à couplage de charges comportant:
une première région plane (22) de matière semiconductrice et
une seconde région plane (20) de matière semiconductrice, recouvrant au moins partiellement la première région plane, des moyens d'arrêt de canal enterrés (24, 26, 28) disposés dans la première région plane et présentant une variation spatiale de la concentration en impuretés électriquement actives dans la première région plane, pour assurer le confinement électrostatique de porteurs de charge mobiles dans la seconde région plane, afin de définir dans celle-ci un canal électrostatique, et un ensemble d'électrodes de grille coplanaires et parallèles (12, 14, 16, 18) qui s'étendent de façon continue sur les moyens d'arrêt de canal enterrés et établissent un contact redresseur avec la seconde région plane.

2. Un dispositif selon la revendication 1, dans lequel la première région plane (22) est dopée avec le type p−, la seconde région plane (20) est dopée avec le type n, les électrodes de grille (12, 14, 16, 18) sont dopées avec le type p+, les moyens d'arrêt de canal (24, 26, 28) consistent en un ensemble de régions coplanaires parallèles dopées avec le type p+ et les porteurs de charge mobiles sont des électrons.

3. Un dispositif selon la revendication 1, dans lequel la première région plane (22) est dopée avec le type n−, la seconde région plane (20) est dopée avec le type p−, les électrodes de grille (12, 14, 16, 18) sont dopées avec le type n+, les moyens d'arrêt de canal (24, 26, 28) consistent en un ensemble de régions coplanaires parallèles dopées avec le type n+ et les porteurs de charge mobiles sont des trous.

Fig. 1.

Fig. 2.

# Fig. 3.

P+

44

N

42

P+

P+

36

38

40

P−

34

# Fig. 4.

56

P +

N

54

B

A

P+

P−

P+

48

52

50

46